# EUROPEAN PATENT APPLICATION

(11) **EP 4 729 852 A1**
(43) Date of publication of application: **22.04.2026**
(21) Application number: 25209292.9
(22) Date of filing: 16.10.2025
(51) Int. Cl.: F25B 5/02, F25B 41/22, F25B 41/24

(54) **REFRIGERANT MANAGEMENT SYSTEM FOR HYBRID AIR/LIQUID COOLING UNIT**

(30) Priority: 16.10.2024 US 202463708012 P; 10.10.2025 US 202519355549
(71) Applicant: Vertiv Corporation, Westerville, OH 43082 (US)
(72) Inventor: Blaser, Colin Lewis, Westerville, 43082 (US); Raven, Matthew Alan, Westerville, 43082 (US); Breuer, Thomas Christopher, Westerville, 43082 (US); Miller, Oliver McKenzey, Westerville, 43082 (US)
(74) Representative: Cousens, Nico

(57) **Abstract**

A cooling system may include a compressor, a condenser, a first heat exchanger, a second heat exchanger, and a storage container configured to store refrigerant. The cooling system may include a set of entry control valves configured to control a flow of the refrigerant selectively to at least one of the first heat exchanger or the second heat exchanger. The cooling system may include a set of outlet control valves configured to control a flow of refrigerant between the first heat exchanger and the second heat exchanger.

## Description

### CROSS-REFERENCE TO RELATED APPLICATIONS

The present application claims the benefit under 35 U.S.C § 119(e) of U.S. Provisional Application No. 63/708,012, filed October 16, 2024.

### TECHNICAL FIELD

The present disclosure relates to cooling systems for electronic equipment, and more particularly, for cooling systems for electronic equipment that are capable of using both air cooling and liquid cooling technologies.

### BACKGROUND

Telecommunication and computing industries rely on cooling systems to keep temperature-sensitive equipment (e.g., servers, computers) operating under rated or normal environmental conditions.

While the first cooling systems were based on heat exchangers that relied on airflow, newer systems often utilize liquid cooling systems for heat transfer. Many companies are looking to update legacy air cooling systems with liquid cooling. However, transitioning from air cooling systems to liquid cooling systems currently requires the purchase and installation of a separate cooling infrastructure, which can be prohibitively expensive, time-consuming, and require changes to be made to the building infrastructure. Transitioning between air cooling systems and liquid cooling systems may also require manually pulling or adding refrigerant, another time-consuming event. Accordingly, it may be advantageous to have a system and method that enables cooling systems to switch over from air cooling to liquid cooling without the aforementioned expense and time inputs.

### SUMMARY

Accordingly, the present disclosure is directed to a hybrid cooling system for electronic equipment, such as servers in a data center. The hybrid cooling system uses both air-cooling and liquid-cooling heat exchangers. In one or more embodiments, the cooling system includes at least one cooling circuit, the cooling circuit including at least one compressor configured to pressurize a refrigerant. In one or more embodiments, the cooling circuit includes at least one condenser configured to transfer heat from the refrigerant to an outside environment. In one or more embodiments, the cooling circuit includes a first heat exchanger configured to transfer heat from ambient air to the refrigerant. In one or more embodiments, the cooling circuit includes a second heat exchanger configured to transfer heat from a liquid to the refrigerant. In one or more embodiments, the cooling circuit includes a set of valves, such as entry control valves, configured to control a flow of refrigerant to the first heat exchanger and the second heat exchanger. In one or more embodiments, the cooling circuit includes a set of outlet control valves configured to control a flow of refrigerant selectively from the first heat exchanger and the second heat exchanger.

A method for switching a cooling system from cooling via a first heat exchanger to cooling via a second heat exchanger, wherein the first heat exchanger utilizes a first volume of refrigerant that is greater than a second volume of refrigerant utilized by the second heat exchanger is also disclosed. In one or more embodiments, the method includes opening one or more second heat exchanger valves, wherein opening one or more second heat exchanger valves enables the flow of the second volume of refrigerant into the second heat exchanger. In one or more embodiments, the method includes closing a first outlet heat exchanger valve. In one or more embodiments, the method includes closing a first inlet heat exchanger valve, wherein closing the first inlet heat exchanger valve and the first outlet heat exchanger valve causes a third volume of refrigerant to be stored in the first heat exchanger.

A method for removing stored refrigerant from at least one heat exchanger of a hybrid cooling system comprising a first heat exchanger, and a second heat exchanger is also disclosed. In one or more embodiments, the method includes closing an outlet heat exchanger valve for the at least one heat exchanger. In one or more embodiments, the method includes heating the at least one heat exchanger, wherein heating the first heat exchanger or second heat exchanger pressurizes the stored refrigerant. In one or more embodiments, the method includes opening the outlet heat exchanger valve, wherein opening the outlet heat exchanger valve releases the stored refrigerant.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated, and some features may be omitted or may be represented schematically in the interest of clarity. Like reference numerals in the drawings may represent and refer to the same or similar element, feature, or function.
FIG. 1 illustrates a block diagram depicting a cooling system for hybrid cooling of electronic equipment, in accordance with one or more embodiments of the disclosure.
FIG. 2 illustrates a block diagram depicting a cooling system for hybrid cooling of electronic equipment that includes a controller, in accordance with one or more embodiments of the disclosure.
FIG. 3 illustrates a block diagram depicting a liquid cooling sub-system, in accordance with one or more embodiments of the disclosure.
FIG. 4 illustrates a schematic view of a cooling system, in accordance with one or more embodiments of the disclosure.
FIG. 5 illustrates a schematic view of a cooling system operating with 100% of the cooling performed via air-cooled heat exchangers, in accordance with one or more embodiments of the disclosure.
FIG. 6 illustrates a simplified schematic view of cooling system operating with 100% of the cooling performed via liquid-cooled heat exchangers, in accordance with one or more embodiments of the disclosure.
FIG. 7 illustrates a simplified schematic view of a cooling system operating with the cooling performed roughly equally between one or more heat exchangers, in accordance with one or more embodiments of the disclosure.
FIG. 8 illustrates a simplified schematic view of a cooling system that includes a first heat exchanger and a second heat exchanger, in accordance with one or more embodiments of the disclosure.
FIG. 9 illustrates a simplified schematic view of a cooling system that includes and/or is in fluid communication with a cooling distribution unit, in accordance with one or more embodiments of the disclosure.
FIG. 10 illustrates a cooling system, in accordance with one or more embodiments of the disclosure.
FIG. 11 illustrates a process flow diagram of a method for switching a cooling system from cooling electronic equipment via a first heat exchanger to cooling electronic equipment via a second heat exchanger, in accordance with one or more embodiments of the disclosure.
FIG. 12 illustrates a process flow diagram of a method for switching a cooling system between cooling via a first heat exchanger and cooling via a second heat exchanger, wherein the first heat exchanger utilizes a first volume of refrigerant that is greater than a second volume of refrigerant utilized by the second heat exchanger, in accordance with one or more embodiments of the disclosure.
FIG. 13 illustrates a process flow diagram of a method of removing stored refrigerant from at least one heat exchanger of a hybrid cooling system, comprising the first heat exchanger and a second heat exchanger, in accordance with one or more embodiments of the disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Disclosed is a hybrid air/liquid cooling system. The hybrid air/liquid cooling system operates with two types of heat exchangers: a first heat exchanger configured as an evaporator coil typically used in air cooling systems, and a second heat exchanger used for liquid cooling, such as a braze plate heat exchanger (BPHE). The hybrid air/liquid cooling system is designed to provide cooling that is 100% air-cooled, 100% liquid-cooled, or a mixture of air cooling and liquid cooling (e.g., 50% air-cooled, 50% liquid-cooled). The hybrid air/liquid cooling system may be initially built as a complete, hybrid cooling system, or be built sequentially by installing and integrating a liquid cooling componentry (e.g., a liquid cooling subsystem) with a legacy air-cooling system. Because the liquid cooling aspects of the hybrid air/liquid cooling system can be added to a legacy air-cooling system, a hybrid air/liquid cooling system provides an operator with the flexibility to convert their cooling system gradually and precisely from air cooling to liquid cooling without the need to purchase and install a separate liquid cooling unit, facilitating a seamless transition from air cooling to liquid cooling.

In some embodiments, the first heat exchanger and/or the second heat exchanger of the hybrid air/liquid cooling system are used to store excess refrigerant. For example, if a first heat exchanger with a relatively large refrigeration capacity is being turned off and the second heat exchanger with a relatively small refrigeration capacity is being turned on, the system may operate valves that cause excess refrigerant to be stored in the now-offline first heat exchanger. The ability of the system to store excess refrigerant in an offline heat exchanger both lessens the need for a dedicated refrigerant storage vessel to be added to the system and reduces the need for an operator to pull the excess refrigerant from the system. If the system switches back to using the first heat exchanger, the excess refrigerant is then reused.

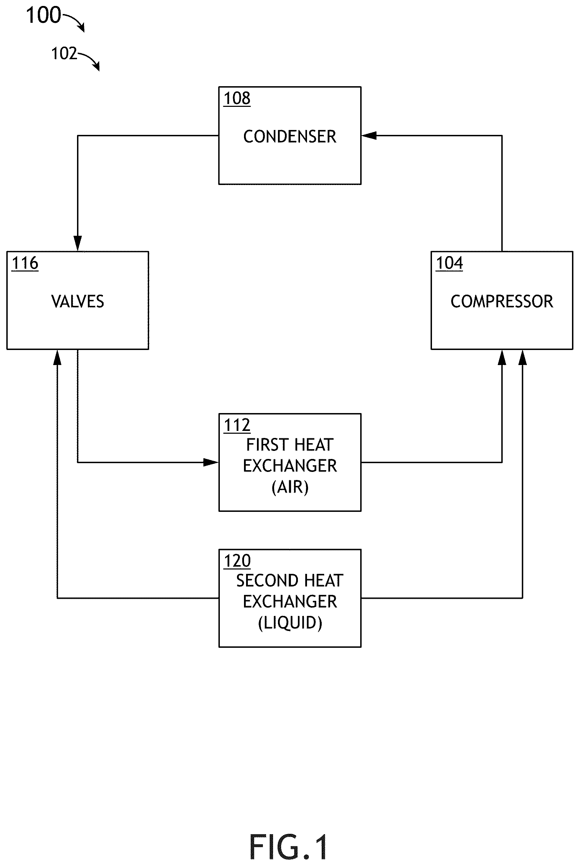

In embodiments, as illustrated in FIG. 1, a cooling system 100 for hybrid cooling of electronic equipment (e.g., a server or server farm/data center) is presented. The cooling system 100 includes one or more compressors 104 configured to pressurize a refrigerant (e.g., a gas refrigerant) within the cooling system 100. Pressurizing the refrigerant raises the temperature of the refrigerant higher than the ambient temperature of air outside of the cooling system 100. The cooling system 100 may use any type of refrigerant including, but not limited to, R22, R410A, R407C, R744, R134a, R1234yf, R290, R600a, R718. In some embodiments, the cooling system may include R454B refrigerant.

In embodiments, the cooling system 100 includes one or more cooling circuits 102 that include one or more condensers 108 containing one or more condenser coils. The one or more condensers 108 transfer heat from the refrigerant to an outside environment (e.g., outside of the cooling system 100). For example, the air (e.g., ambient temperature air) may be blown across the condenser coil by a fan. Heat is then transferred from the refrigerant (e.g., vapor refrigerant) to the air of the outside environment. This condenses the refrigerant into a liquid. The colder refrigerant then heads back to an evaporator coil to recollect heat. As used herein, a component of the cooling system 100 may also be a component of the one or more cooling circuits 102, as the cooling system 100 comprises the one or more cooling circuits 102.

In embodiments, the cooling system 100 includes a first heat exchanger 112 configured to transfer heat from ambient air to the refrigerant. The first heat exchanger 112 includes the aforementioned evaporator coil. When in use, heated air is blown across one or more evaporator coils of the first heat exchanger 112, causing the refrigerant to evaporate into a vapor/gas. This heat transfer cools the air, which is then returned to the electronic equipment to elicit the cooling effect.

In embodiments, the cooling system 100 includes a set of one or more valves 116 (e.g., expansion valves). The one or more valves 116 facilitate control of the flow of the refrigerant selectively through the first heat exchanger 112 and a second heat exchanger 120 to the one or more compressors 104. The one or more valves 116 control one or more qualities of the refrigerant, such as the percentage of refrigerant flowing as a liquid or as a gas/vapor, and ensures that the refrigerant is in gas/vapor form before returning to the compressors 104, as liquids are incompressible and may damage the one or more compressors 104.

In embodiments, the cooling system 100 includes the second heat exchanger 120. The second heat exchanger 120 is configured to transfer heat from a secondary liquid (e.g., liquid from a secondary cooling system) to the refrigerant. For example, the second heat exchanger 120 may transfer heat from the secondary fluid, e.g., (typically water or propylene glycol) to the refrigerant. The second heat exchanger 120 may include, but not be limited to a brazed plate heat exchanger (BPHE). A BPHE uses both conduction and convection to transfer heat as the secondary fluid passes through the plates of the BPHE, without a need for a blower or fan. Within the one or more cooling circuits 102, the first heat exchanger 112 and the second heat exchanger 120 utilize the same refrigerant (e.g., a portion of the refrigerant that has flowed through the first heat exchanger 112 will also flow through the second heat exchanger 120).

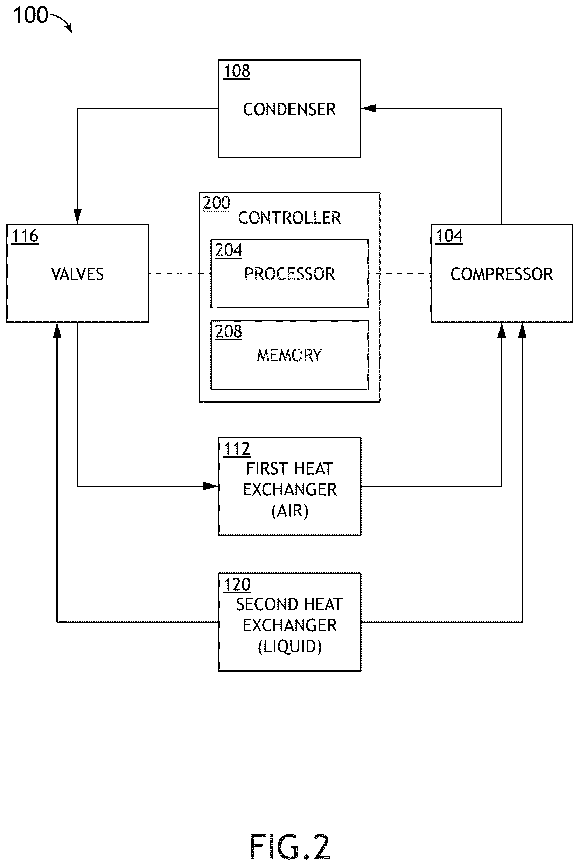

In embodiments, the cooling system 100 includes a controller 200 configured to control one or more processes within the cooling system 100, as shown in FIG. 2. For example, the controller 200 may control the action of the one or more valves 116 of the system. The controller 200 may control other aspects or components of the cooling system 100 including but not limited to, the one or more compressors 104, one or more fans/blowers operating within the cooling system 100, and/or controllable aspects of the condenser 108, the first heat exchanger 112 and the second heat exchanger 120. The controller 200 includes one or more processors 204 and memory 208 that facilitate the controller 200 in controlling one or more functions of the cooling system 100. In embodiments, the one or more processors 204 are configured to receive instructions (e.g., from memory 208 or from an input from an operator via a user interface) to open or close one or more valves 116 of the set of valves, as described herein. In embodiments, the one or more processors 204 are configured to transmit a signal to the one or more valves 116 of the set of valves based on the instruction, as described herein.

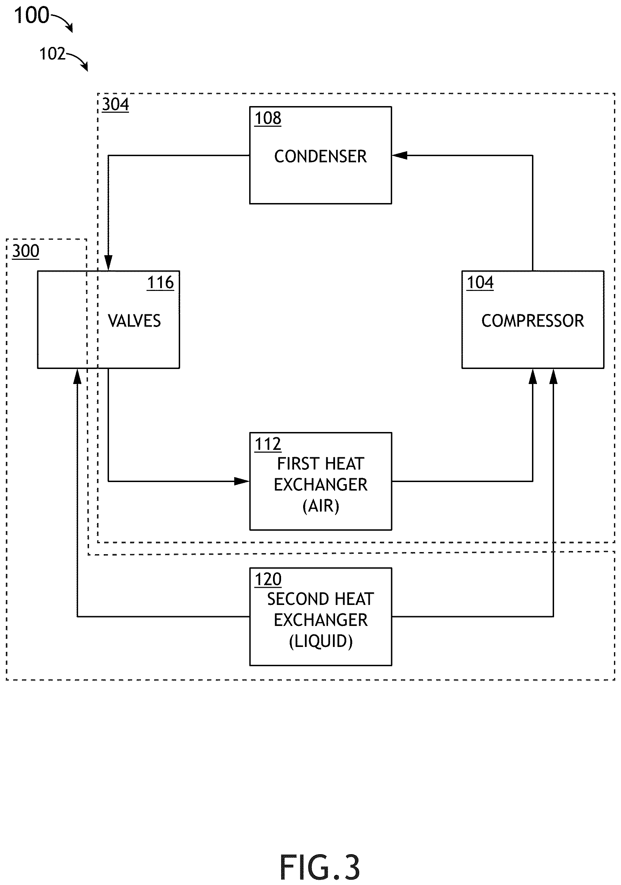

In embodiments, a liquid cooling sub-system 300 is disclosed, in accordance with one or more embodiments of the disclosure, as shown in FIG. 3. In embodiments, the liquid cooling sub-system 300 includes the second heat exchanger 120 (e.g., the BPHE). The liquid cooling sub-system 300 may also include one or more valves 115 of the set of valves. In embodiments, the liquid cooling sub-system 300 is added to, or integrated with, another cooling system to form a hybrid cooling system 100. For example, the liquid cooling sub-system 300 can be added to, or integrated with, a legacy air-cooling system 304 (e.g., an air-cooling subsystem that includes the first heat exchanger 112 and other componentry, such as a DP400 cooling system manufactured by the Vertiv company), to create a hybrid cooling system 100. Therefore, the cooling system 100 of this application may include the liquid cooling sub-system 300 that is integrated into a preexisting air-cooled subsystem or may include both the liquid cooling sub-system and a new or preexisting air-cooled subsystem.

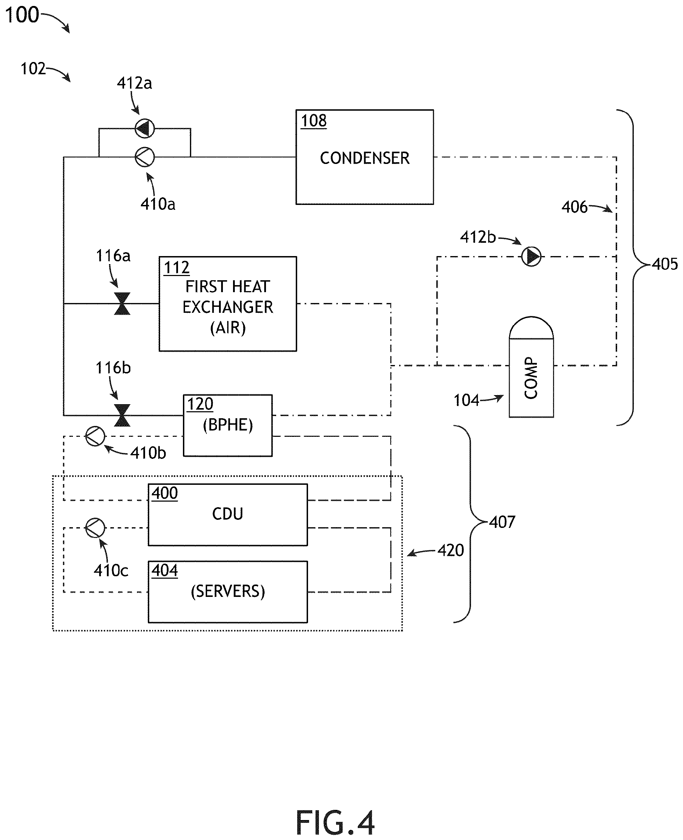

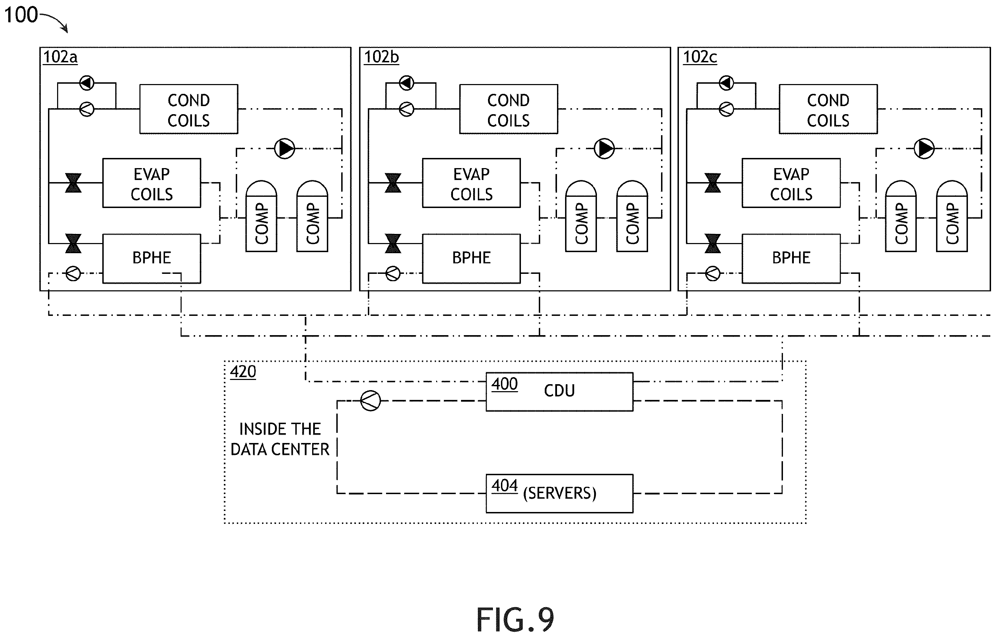

A detailed schematic view of the cooling system 100 is shown in FIG. 4, in accordance with one or more embodiments of the disclosure. In embodiments, with reference to FIG. 9, the cooling system 100 includes and/or is in fluid communication with, a cooling distribution unit (e.g., CDU 400). The CDU 400 receives chilled secondary fluid from the second heat exchanger 120 and circulates the chilled secondary fluid, or a chilled tertiary fluid (e.g., water or propylene glycol) that has exchanged heat with the secondary fluid via the CDU 400, to the electronic equipment 404 (e.g., servers). The electronic equipment 404 heats up the secondary fluid or tertiary fluid, and heat from these fluids is transferred back to the second heat exchanger 120 via circulation. In embodiments, the secondary fluid may also be circulated directly between the second heat exchanger 120 and the electronic equipment 404 (e.g., the CDU 400 being optional). The cooling system 100 may be defined as including both an air-cooled subsystem 405 that includes a set of refrigerant lines 406 for circulating the refrigerant and a liquid-cooled sub-system.

As shown in FIG. 4, the cooling system 100 includes a valve 116a which controls the flow of refrigerant to the first heat exchanger 112, and a valve 116b which controls the flow of refrigerant to the second heat exchanger 120. The cooling system 100 may also include one or more pumps 410a-c. For example, the cooling system 100 may include a pump 410a that facilitates the circulation of refrigerant. In another example, the cooling system 100 may include one or more pumps 410b-c configured to circulate secondary fluid through the second heat exchanger 120, the electronic equipment 404 (e.g., to computer chips within the servers) and/or the CDU 400. The cooling system 100 may also include one or more check valves 412a-b configured to prevent backflow of refrigerant. The one or more pumps 410a-c and one or more check valves 112a-b may be part of a complementary heating system that adds efficiency to the system 100. For example, one or more pumps 410a and check valves 412a-b may facilitate the circulation of refrigerant without the use of the one or more compressors 104. For instance, in times when the temperature outside is colder than the saturation temperature of the refrigerant, the system 100 may rely on the one or more pumps 410a and check valves 412a-b to circulate refrigerant in the absence of the compressor, reducing the power expended to circulate refrigerant. Because this aspect of cooling is complementary to compressormediated cooling, the one or more pumps 410a and one or more check valves 112a-b may be optional.

In embodiments, a portion of the cooling system 100 is physically located within a server environment 420 (e.g., the location of the servers or other electronic equipment 404 (data centers). For example, the CDU and the electronic equipment 404 being cooled may be located within the server environment 420. In another example, the CDU, the electronic equipment 404, and the second heat exchanger 120 may be located within the server environment. In another example, the electronic equipment 404 is within the server environment 420.

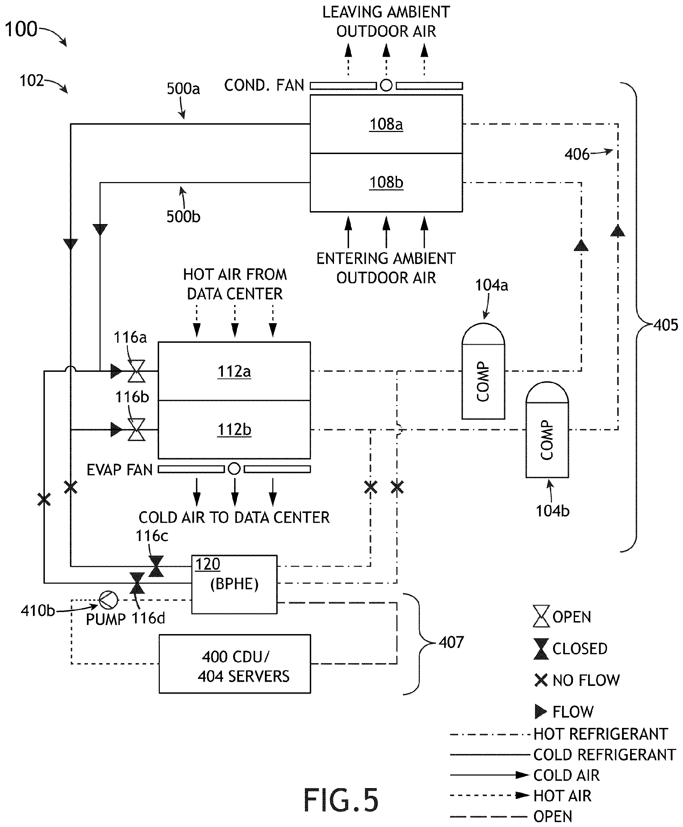

FIGS. 5-7 illustrate a more detailed schematic view of the cooling system 100 operating under different conditions. FIGS. 5-7 illustrate the cooling system 100 with one or more compressors 104a-b, one or more condensers 108a-b (e.g., multiple condenser coils), first one or more heat exchangers 112a-b (e.g., multiple evaporator coils), as well as multiple valves 116a-d (e.g., first heat exchanger valves 116a-b and second heat exchanger valves 116c-d). The cooling system 100 may include any number of compressors 104, condensers 108, first one or more heat exchangers 112a-b, and a second heat exchanger 120. The cooling system 100 may include multiple primary refrigerant circulation loops 500a-b. the system may also include one or more secondary cooling loops 502. For example, the one or more cooling circuits 102 of the cooling system 100 may include, or be in fluid communication with, two secondary cooling loops 502.

FIG. 5 illustrates the cooling system 100 operating with 100% of the cooling performed via the air-cooled first one or more heat exchangers 112a-b, in accordance with one or more embodiments of the disclosure. In this configuration, the first heat exchanger valves 116a-b are open (e.g., as indicated by the white valve icon), while the second heat exchanger valves 116c-d are closed (e.g., as indicated by the black valve icon), allowing refrigerant to circulate through the first one or more heat exchangers 112a-b, and preventing refrigerant from circulating through the second heat exchanger 120. Areas of circulation are denoted with an arrow in FIGS. 5-7, while areas of no flow are denoted by an "x".

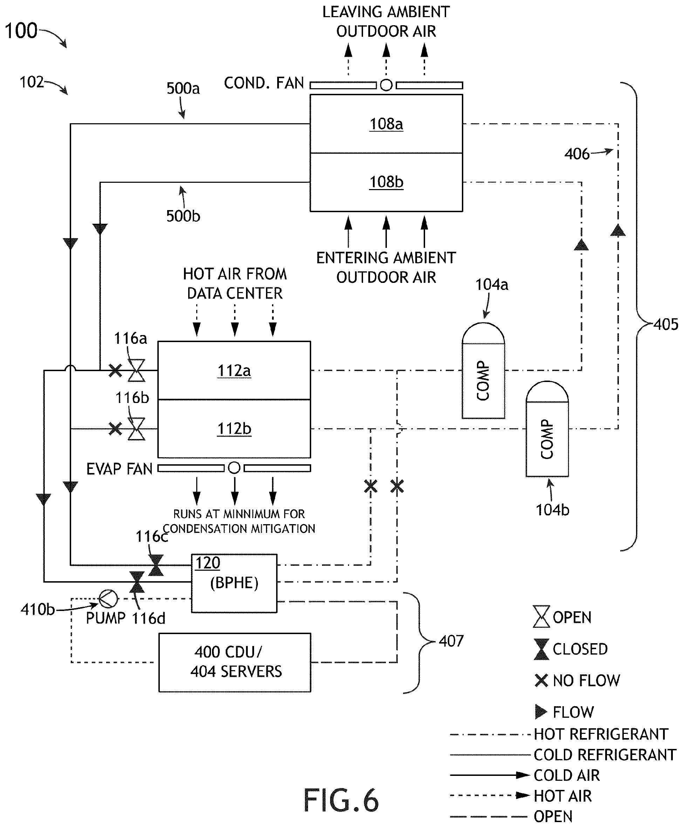

FIG. 6 illustrates the cooling system 100 operating with 100% of the cooling performed via the liquid-cooled second heat exchanger 120, in accordance with one or more embodiments of the disclosure. In this configuration, the first heat exchanger valves 116a-b are closed while the second heat exchanger valves 116c-d are open, allowing refrigerant to circulate through the second heat exchanger 120, and preventing refrigerant from circulating through the first one or more heat exchangers 112a-b. Areas of circulation are denoted with an arrow, while areas of no flow are denoted by an "x".

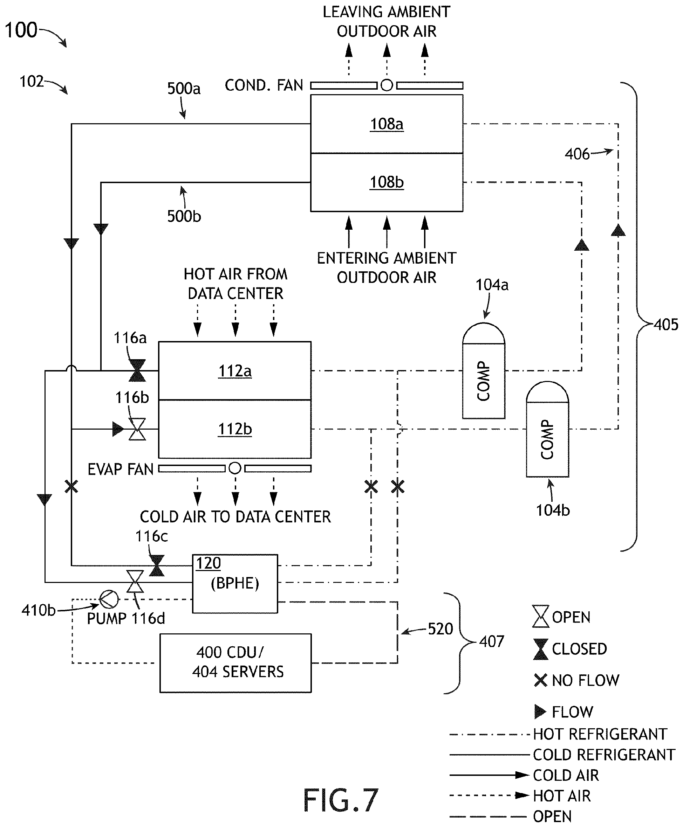

FIG. 7 illustrates the cooling system 100 operating with the cooling performed roughly equally between the first one or more heat exchangers 112a-b and the liquid-cooled second heat exchanger 120, in accordance with one or more embodiments of the disclosure. In this configuration, one of the first heat exchanger valves 116a is closed with the other first heat exchanger valve 116b is opened, while one of the second heat exchanger valves 116c is closed with the other second heat exchanger valve 116d opened, allowing refrigerant to be cooled by both air-cooling and liquid-cooling technologies. The cooling system 100 may be configured to allow any percentage of cooling to be performed by either the first one or more heat exchanger 112 or the second heat exchanger 120. For example, the ratio of percentages of cooling between the first one or more heat exchangers 112 and the second heat exchanger 120 may be 50% (air):50% (liquid). The switching of the valves 116a-d may be performed manually or via the controller 200.

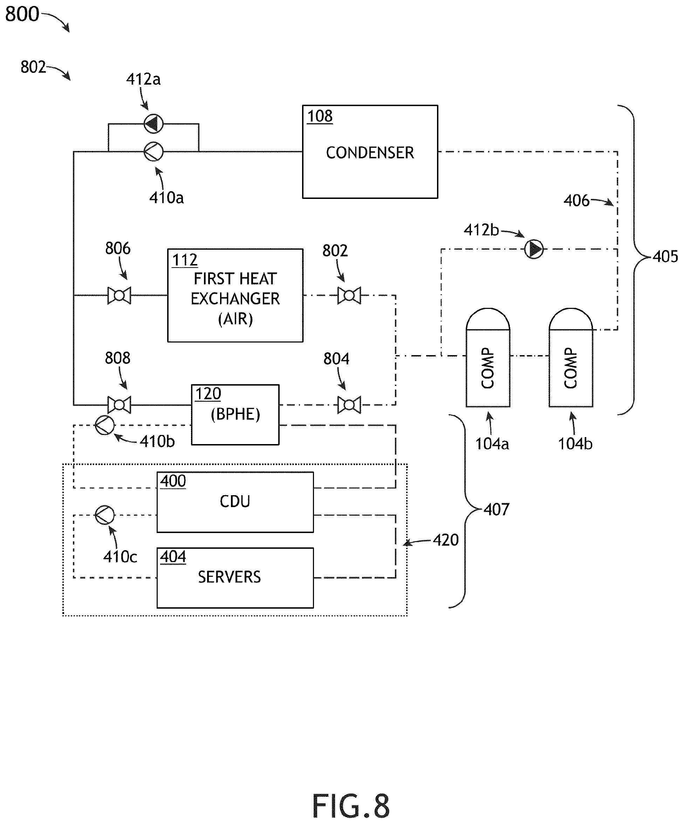

FIG. 8 illustrates a cooling system 800 that includes both the first heat exchanger 112 and the second heat exchanger 120, in accordance with one or more embodiments of the disclosure. The cooling system 800 may include one or more components of cooling system 100. In embodiments, the cooling system 800 includes at least one first heat exchanger outlet control valve 802, and at least one second heat exchanger outlet control valve 804 (e.g., together referred to as a set of outlet control valves). In embodiments, the cooling system 800 further includes at least one first heat exchanger entry control valve 806, and at least one second heat exchanger entry control valve 808 (e.g., together referred to as a set of entry control valves).

The at least one first heat exchanger entry control valve 806, and the at least one second heat exchanger entry control valve 808 are configured to control a flow of the refrigerant selectively to the respective first heat exchanger 112 and the second heat exchanger 120, whereas the at least one first heat exchanger outlet control valve 802, and at least one second heat exchanger outlet control valve 804 are configured to control a flow of refrigerant selectively from the first heat exchanger and the second heat exchanger. The set of control valves 802-808 may include or more expansion valves. In embodiments, the control valves 802-808 are configured so that one of the first heat exchanger 112 or the second heat exchanger 120 is actively used during operation of the system 800 (e.g., engaged in a refrigeration cycle), with the other of the first heat exchanger 112 or the second heat exchanger 120 inactive (e.g., not engaged in the refrigeration cycle). The inactive heat exchanger may then be used to store refrigerant. For example, the system 800 may be designed for using the first heat exchanger 112, an evaporator coil for air cooling a data center, and a second heat exchanger 120, a BPHE for directed chip cooling in the data center. However, the operator may want only one heat exchanger to be used at one time and switch the use of one heat exchanger or cooling sub-system off and turn the other heat exchanger or cooling sub-system on.

When switching between a heat exchanger having a relatively high refrigerant charge volume, such as the first heat exchanger 112, to a heat exchanger having a relatively low refrigerant charge volume, such as the second heat exchanger 120, there will be a need to reduce the amount of refrigerant in the system 100 for use by the second heat exchanger 120. While the excess refrigerant could be released from the system 100 or moved to a storage container, the first heat exchanger could be used to store the excess refrigerant. For example, one or more of the at least one first heat exchanger outlet control valve 802 and/or the at least one first heat exchanger entry control valve 806 may be initially closed so that refrigerant is directed to the use by the second heat exchanger 120. The at least one second heat exchanger outlet control valve 804 and the at least one second heat exchanger entry control valve 808 would be opened to receive refrigerant. Once the second heat exchanger 120 has the correct amount of refrigerant to operate, the closing of the at least one first heat exchanger outlet control valve 802 and the at least one first heat exchanger entry control valve 806 will trap and store excess refrigerant in the first heat exchanger 112.

When switching from using the second heat exchanger 120 to the first heat exchanger 112, the process may be adjusted or reversed where the at least one second heat exchanger outlet control valve 804 and/or the at least one second heat exchanger entry control valve 808 are closed in order to redirect refrigerant is directed for used by the first heat exchanger 112. The at least one first heat exchanger outlet control valve 802 and at least one first heat exchanger entry control valve 806 would be opened to receive refrigerant. If there is excess refrigerant in the system 800, the closing of at least one second heat exchanger outlet control valve 804 and at least one second heat exchanger entry control valve 808 will trap and store excess refrigerant in the second heat exchanger 120. Control of the control valves 802-808 for controlling the flow and storage of refrigerant between the first heat exchanger 112 and the second heat exchanger 120 may be made by the controller 200.

While using the first heat exchanger 112 and/or second heat exchanger 120 for refrigerant storage provides an elegant solution for storing excess refrigerant, removing the stored refrigerant from the first heat exchanger 112 and/or second heat exchanger 120 may require further processing steps such as adding heat to the first heat exchanger 112 and/or the second heat exchanger 120 that increases the pressure of the refrigerant. In embodiments, the heat from the surrounding environment is used to heat up the refrigerant in the first heat exchanger 112 and/or second heat exchanger 120. For example, hot air produced within the environment, such as the hot air produced in a data center from the warming caused by computer processing (e.g., a heat source), may be directed and/or blown toward the first heat exchanger 112. Refrigerant stored in the first heat exchanger 112 may be heated up by the hot air, causing a buildup of pressure within the first heat exchanger 112. For refrigerant stored in the second heat exchanger 120, hot air may also be blown across the second heat exchanger 120, causing an increase in refrigerant pressure. Opening the at least one second heat exchanger outlet control valve 804 may then release the pressure and cause the refrigerant to be expelled from the second heat exchanger 120. In embodiments, refrigerant stored in liquid form in the first heat exchanger 112 and/or the second heat exchanger 120 is evaporated into a vapor form by heating the first heat exchanger 112 and/or the second heat exchanger 120 with heated air within the environment (e.g., via fans).

In embodiments, the cooling system 100 includes one or more cooling circuits 102a-c, in accordance with one or more embodiments of the disclosure, and as shown in FIG. 9. The cooling system 100 may have any number of cooling circuits 102a-c including, but not limited to one cooling circuit 102, two cooling circuits 102, three cooling circuits 102, ten cooling circuits 102, 30 cooling circuits 102, or 100 or more cooling circuits 102. For example, the cooling system 100 may include up to 32 cooling circuits 102. The cooling circuits 102a-c may be in fluid communication with any number of CDUs 400 or electronic equipment 404 (e.g., servers) and may be organized in parallel with a set of CDUs 400 or electronic equipment 404. For example, the set of CDUs 400 and/or electronic equipment 404 may be paralleled together up to 32 cooling circuits.

In embodiments, one or more processors 204 are configured to receive instructions specific for each set of valves 116 (e.g., ON and OFF instructions) of the one or more cooling circuits 102. The one or more processors 204 may also be configured to transfer a signal to the valves 116 based on the instructions for each of the cooling circuits. For example, for a cooling system 100 with ten cooling circuits 102, the cooling system 100 may be instructed to, and be executed by the one or more processors 204 of the controller 200 to, operate the valves 116 so that three of the cooling circuits 102 operate with 100% air-cooling and seven of the cooling circuits 102 operate with 100% liquid-cooling. In this manner, the ratio of cooling between the first one or more heat exchangers 112 and the second heat exchanger 120 for the entire cooling system 100 can be adjusted based on the opening and closing of valves 116 within each cooling circuit 102.

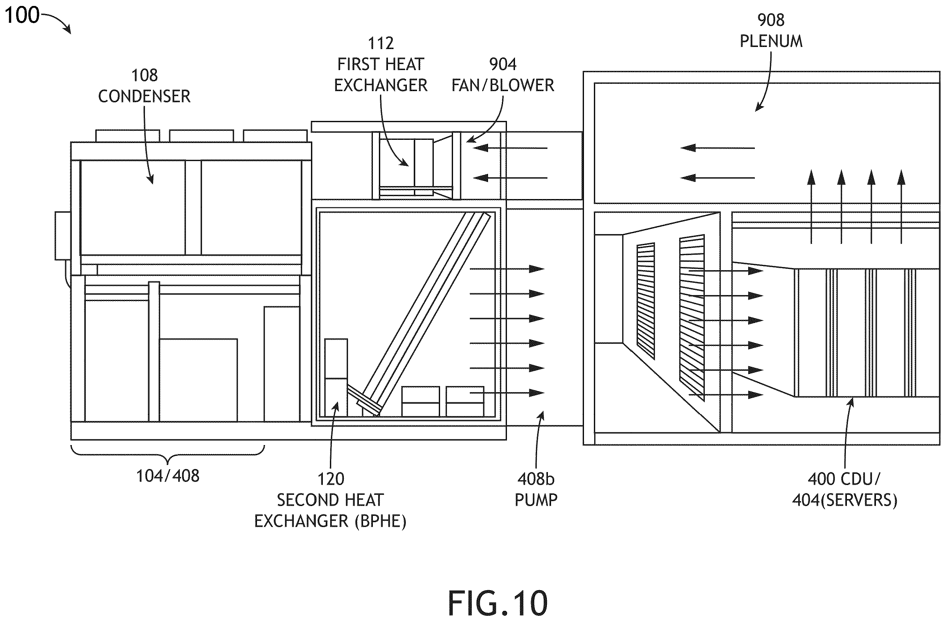

A form factor for housing the cooling system 100 is shown in FIG. 10, in accordance with one or more embodiments of the disclosure. The coordinated cooling of refrigerant by the first heat exchanger 112 and the second heat exchanger 120 causes cooled air and/or cooled liquid to enter the electronic equipment 404 (with or without CDUs 400). Air may be circulated by one or more fans/blowers 904. Air that is heated by the electronic equipment 404 then rises into a plenum 908 and may be circulated back to the first heat exchanger 112 for another round of cooling. The cooling system 100 may be designed to fit into one or more form factors. For example, the cooling system 100 may be configured to have the same or similar width or height as the aforementioned DP400 cooling system.

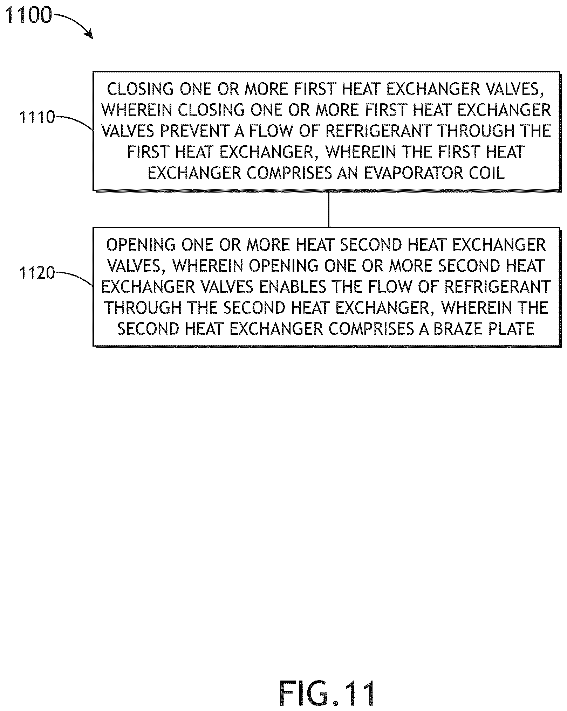

FIG. 11 illustrates a process flow diagram of a method 1100 for switching a cooling system 100 from cooling electronic equipment 404 via the first heat exchanger 112 to cooling electronic equipment 404 via a second heat exchanger 120, in accordance with one or more embodiments of the disclosure and as illustrated in FIG. 11. One or more steps of the method 1100 may be performed manually or via the one or more processors 204. The method 1100 is further illustrated in FIGS. 5-6.

In embodiments, the method 1100 includes a step 1110 of closing one or more first heat exchanger valves 116a-b, wherein closing one or more first heat exchanger valves 116a-b prevents a flow of refrigerant through the first heat exchanger 112, wherein the first heat exchanger 112 comprises an evaporator coil. In embodiments, the method 1100 includes a step 1120 of opening one or more heat second heat exchanger valves 116c-d, wherein opening one or more second heat exchanger valves 116c-d enables the flow of refrigerant through the second heat exchanger 120, wherein the second heat exchanger 120 comprises a braze plate heat exchanger (BPHE).

In embodiments, method 1100 further includes changing the amount of refrigerant (e.g., charge) in the cooling system 100. The amount of refrigerant in the system will vary whether the one or more cooling circuits 102 are operating as air-cooled or liquid cooled. This is because the amount of refrigerant in the first heat exchanger 112 (e.g., an evaporator coil) is likely larger than the amount of charge in the second heat exchanger 120 (e.g., BPHE). In addition, the refrigerant migrates and depending on when they shut down the unit to transition, the refrigerant may migrate and sit in the first heat exchanger 112. This may require a technician to pull refrigerant out of the one or more cooling circuits 102 and then recharge the cooling system 100 to a newly calculated amount. This issue may be solved with a receiver that can hold an extra refrigerant charge.

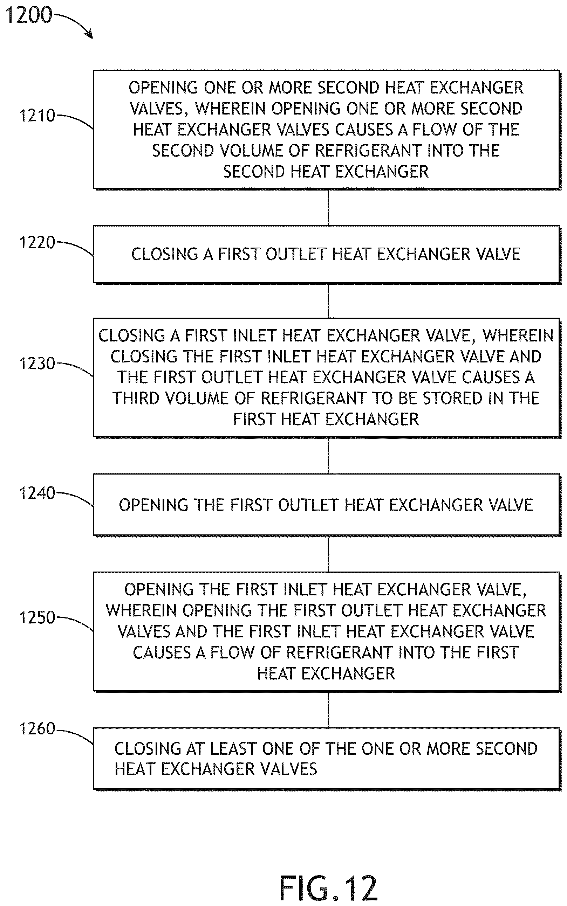

FIG. 12 illustrates a process flow diagram of a method 1200 for switching a cooling system 800 between cooling via a first heat exchanger 112 and cooling via a second heat exchanger 120, wherein the first heat exchanger 112 utilizes a first volume of refrigerant that is greater than a second volume of refrigerant utilized by the second heat exchanger 120, in accordance with one or more embodiments of the disclosure. The method 1200 may be utilized by cooling systems 100, 800 as described herein. The method 1200 may be performed at least in part via the one or more controllers 200.

In embodiments, the method 1200 includes a step 1210 of opening one or more heat second heat exchanger valves 804. 808, wherein opening one or more second heat exchanger valves 804, 808 enables the flow of the second volume of refrigerant into the second heat exchanger 120.

In embodiments. The method 1200 includes a step 1220 of closing a first outlet heat exchanger valve 802. In embodiments, the method includes a step 1230 of closing a first inlet heat exchanger valve 806, wherein closing the first inlet heat exchanger valve 806 and the first outlet heat exchanger valve 802 causes a third volume of refrigerant to be stored in the first heat exchanger 112. For example, the third volume may be considered an excess or stored volume of refrigerant that, while used for the larger volume first heat exchanger 112 (e.g., a high-refrigerant volume evaporator coil), cannot be while the lower volume second heat exchanger 120 (e.g., a BPHE) is online and the first heat exchanger 112 is offline.

The ability of the first heat exchanger 112 and/or second heat exchanger 120 to act as a storage vessel for excess refrigerant provides a solution for managing the refrigerant level in a cooling system 100,800 automatically through software (e.g., via the controller 200). The methods 1100, 1200 can be used during transitions between the two cooling modes, and also may be used during varying changes in ambient temperature where changes in refrigerant in the online or active part of the system 100, 800 are needed to increase cooling performance.

In embodiments, the method 1200 may further include steps for returning the flow of the refrigerant from the second heat exchanger 120 to the first heat exchanger 112. For example, the method 1200 may include a step 1240 of opening the first outlet heat exchanger valve 802. In another example, the method 1200 may further include a step 1250 of opening the first inlet heat exchanger valve 806, wherein opening the first outlet heat exchanger valves 802 and the first inlet heat exchanger valve 806 causes a flow of refrigerant into the first heat exchanger 112. The method 1200 may further include a step 1260 of closing at least one of the one or more second heat exchanger valves 804, 808.

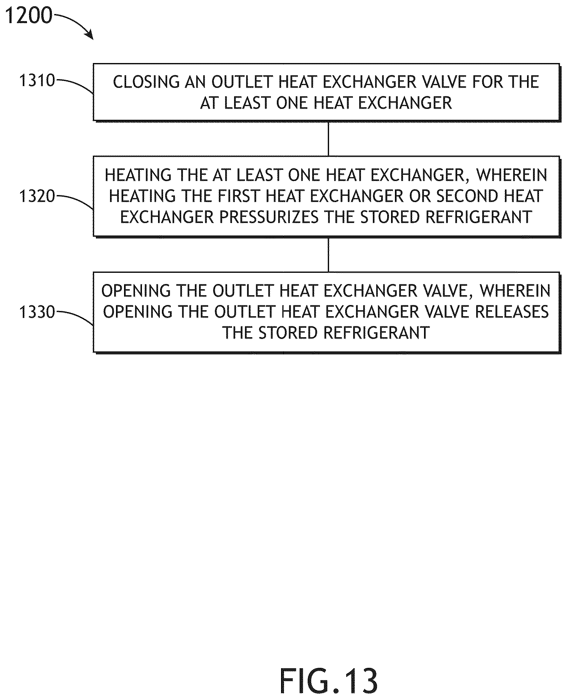

FIG. 13 illustrates a process flow diagram of a method 1300 of removing stored refrigerant from a least one heat exchanger of a hybrid cooling system 100, 800 comprising the first heat exchanger 112 and a second heat exchanger 120. In embodiments, the method 1300 comprises a step 1310 of closing an outlet heat exchanger valve for the at least one heat exchanger (e.g., the first heat exchanger 112 or the second heat exchanger 120). In embodiments, the method 1300 comprises a step 1320 of heating the at least one heat exchanger 112, 120, wherein heating the first heat exchanger or second heat exchanger pressurizes the stored refrigerant. In embodiments, the method 1300 comprises a step 1330 of opening the outlet heat exchanger valve, wherein opening the outlet heat exchanger valve releases the stored (and pressurized) refrigerant. For example, heat from a heat source (e.g., the heat-producing aspects that the air-cooled sub-system 405 or the liquid-cooled sub-system 407 are intended to cool, such as server processors) may be directed to the first heat exchanger 112 and/or the second heat exchanger 120 (e.g., via fans) causing the refrigerant inside the heat first heat exchanger 112 and/or second heat exchanger 120 to pressurize and then be released.

In embodiments, the cooling system 100 does not flow refrigerant through the first heat exchanger 112 and the second heat exchanger 120 at the same time (e.g., within the same cooling circuit 102), unless refrigerant is being stored within, or being added to, the cooling system 100. For example, for a cooling system 100 that includes four cooling circuits 102, one of the cooling circuits 102 may flow refrigerant through the first heat exchanger 112 while the other three circuits may flow through the second heat exchanger 120. An operator may then change the operation of the cooling system 100 so that two cooling circuits flow refrigerant through the first heat exchanger 112 and the other two circuits are flowing refrigerant through the second heat exchanger 120. In this example, the only time that refrigerant would flow to both the first heat exchanger 112 and the second heat exchanger is when storing refrigerant in the first heat exchanger 112 and/or second heat exchanger 120 or when or when adding refrigerant back into the cooling system 100.

The one or more processors 204 may be implemented as any suitable processor(s), such as at least one general purpose processor, at least one central processing unit (CPU), at least one image processor, at least one graphics processing unit (GPU), at least one field-programmable gate array (FPGA), and/or at least one special purpose processor configured to execute instructions for performing (e.g., collectively performing if more than one processor) any or all of the operations disclosed throughout.

Also disclosed are the following numbered items:
1. A method for removing stored refrigerant from a least one heat exchanger of a hybrid cooling system comprising a first heat exchanger and a second heat exchanger comprising:
   closing an outlet heat exchanger valve for the at least one heat exchanger;
   heating the at least one heat exchanger, wherein heating the first heat exchanger or second heat exchanger pressurizes the stored refrigerant; and
   opening the outlet heat exchanger valve, wherein opening the outlet heat exchanger valve releases the stored refrigerant.
2. The method of item 1, wherein the hybrid cooling system is configured to remove heat from a heat source, wherein the heating the at least one exchanger comprises directing heat from the heat source onto the at least one heat exchanger.
3. The method of item 2, wherein the heat from the heat source is directed to the at least one heat exchanger via one or more fans.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application-specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

As used throughout and as would be appreciated by those skilled in the art, "at least one non-transitory computer-readable medium" or "memory 208" may refer to as at least one non-transitory computer-readable medium (e.g., e.g., at least one computer-readable medium implemented as hardware; e.g., at least one non-transitory processorreadable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A cooling system comprising:
at least one cooling circuit comprising:
at least one compressor configured to pressurize a refrigerant;
at least one condenser configured to transfer heat from the refrigerant to an outside environment;
a first heat exchanger configured to transfer heat from ambient air to the refrigerant;
a second heat exchanger configured to transfer heat from a liquid to the refrigerant;
a storage container configured to store refrigerant,
a set of entry control valves configured to control a flow of the refrigerant selectively to at least one of the first heat exchanger or the second heat exchanger; and
a set of outlet control valves configured to control a flow of refrigerant between the first heat exchanger and the second heat exchanger.

2. The cooling system of claim 1, wherein the first heat exchanger is configured to store excess refrigerant when the first heat exchanger is not engaged in a refrigeration cycle and the second heat exchanger is engaged in a refrigeration cycle.

3. The cooling system of claim 1 or 2, wherein the second heat exchanger is configured to store excess refrigerant when the second heat exchanger is not engaged in a refrigeration cycle and the first heat exchanger is engaged in a refrigeration cycle.

4. The cooling system of any preceding claim, wherein the first heat exchanger comprises an evaporator coil.

5. The cooling system of any preceding claim, wherein the second heat exchanger comprises a braze plate heat exchanger "BPHE".

6. The cooling system of any preceding claim, wherein the wherein the first heat exchanger comprises an evaporator coil, wherein the second heat exchanger comprises a braze plate heat exchanger (BPHE).

7. The cooling system of any preceding claim, further comprising at least one cooling distribution unit in fluid communication with the second heat exchanger.

8. The cooling system of any preceding claim further comprising:
a first pump configured to circulate a refrigerant; and
a second pump configured to circulate a secondary fluid through the second heat exchanger, and optionally
wherein the secondary fluid is configured to remove heat from computer chips within a server.

9. The cooling system of any preceding claim, further comprising one or more processors communicatively coupled to one or more of the set of entry control valves or the set of outlet control valves, the one or more processors configured to:
receive an instruction to open or close one or more valves of the set of valves; and
transmit a signal to the one or valves of the set of valves based on the instruction.

10. The cooling system of claim 9, further comprising a plurality of cooling circuits, wherein the one or more processors are further configured to receive instructions specific for each set of valves for each cooling circuit of the plurality of cooling circuits.

11. The cooling system of claim 9 or 10, wherein the cooling system is configured to switch between cooling via a first heat exchanger utilizing a first volume of refrigerant and cooling via a second heat exchanger utilizing a second volume of refrigerant, wherein the one or more processors are configured to:
cause an opening of one or more second heat exchanger valves, wherein opening one or more second heat exchanger valves causes a flow of the second volume of refrigerant into the second heat exchanger;
cause a closing of a first outlet heat exchanger valve; and
cause a closing of a first inlet heat exchanger valve, wherein closing the first inlet heat exchanger valve and the first outlet heat exchanger valve causes a third volume of refrigerant to be stored in the first heat exchanger.

12. The cooling system of claim 11, wherein the one or more processors are further configured to:
cause an opening of the first outlet heat exchanger valve;
cause an opening of the first inlet heat exchanger valve, wherein opening the first outlet heat exchanger valves and the first inlet heat exchanger valve causes a flow of refrigerant into the first heat exchanger; and
cause a closing of at least one of the one or more second heat exchanger valves.

13. The cooling system of any of claims 9 to 12, wherein the cooling system is configured to remove stored refrigerant, wherein the one or more processors are configured to:
cause a closing of an outlet heat exchanger valve for the at least one heat exchanger, wherein a heating of the at least one heat exchanger, pressurizes the stored refrigerant; and
cause an opening of the outlet heat exchanger valve, wherein opening the outlet heat exchanger valve releases the stored refrigerant.

14. A method for switching a cooling system between cooling via a first heat exchanger utilizing a first volume of refrigerant and cooling via a second heat exchanger utilizing a second volume of refrigerant, the method comprising:
opening one or more second heat exchanger valves, wherein opening one or more second heat exchanger valves causes a flow of the second volume of refrigerant into the second heat exchanger;
closing a first outlet heat exchanger valve; and
closing a first inlet heat exchanger valve, wherein closing the first inlet heat exchanger valve and the first outlet heat exchanger valve causes a third volume of refrigerant to be stored in the first heat exchanger , and optionally
wherein the third volume of refrigerant comprises a stored volume of refrigerant.

15. The method of claim 14, further comprising:
opening the first outlet heat exchanger valve;
opening the first inlet heat exchanger valve, wherein opening the first outlet heat exchanger valves and the first inlet heat exchanger valve causes a flow of refrigerant into the first heat exchanger; and
closing at least one of the one or more second heat exchanger valves.
